# EUROPEAN PATENT APPLICATION

(11) **EP 4 411 841 A1**
(43) Date of publication of application: **07.08.2024**
(21) Application number: 23855828.2
(22) Date of filing: 28.11.2023
(51) Int. Cl.: H01L 31/18, H01L 31/0216, H01L 31/06

(54) **SOLAR CELL AND PREPARATION METHOD THEREFOR**

(30) Priority: 22.12.2022 CN 202211658513
(71) Applicant: Tongwei Solar (Meishan) Co., Ltd., Meishan, Sichuan 620041 (CN)
(72) Inventor: XU, Wenzhou, Meishan, Sichuan 620041 (CN); XING, Guoqiang, Meishan, Sichuan 620041 (CN)
(74) Representative: Marks & Clerk LLP
(86) International application number: PCT/CN2023/134621
(87) International publication number: WO 2024/131475

(57) **Abstract**

The present application relates to a solar cell and a preparation method thereof, which includes: providing a silicon wafer, firstly forming a P-type doped layer and an N-type doped layer on a front side and a backside of the silicon wafer, respectively, then forming a first aluminum oxide passivation layer and a second aluminum oxide passivation layer on surfaces of the P-type doped layer and the N-type doped layer, respectively, then forming a first silicon nitride anti-reflection layer and a second silicon nitride anti-reflection layer on surfaces of the first aluminum oxide passivation layer and the second aluminum oxide passivation layer, respectively, and lastly forming an electrode by a screen printing. The P-type doped layer is obtained by vapor deposition, and a deposition temperature is 400°C to 600°C.

## Description

### RELATED APPLICATION

This application claims priority to Chinese Patent Application No. 202211658513.2, entitled "SOLAR CELL AND PREPARATION METHOD THEREOF", filed on December 22, 2022, the content of which is incorporated herein by reference in its entirety.

### TECHNICAL FIELD

The present application relates to the technical field of solar cells, particularly relates to a solar cell and a preparation method thereof.

### BACKGROUND

In crystalline silicon solar cells, there is severe recombination in contact regions of metal and semiconductor, resulting in a relatively large carrier recombination rate and a relatively high saturation current density (10), which has become an important factor restricting the development of the efficiency of crystalline silicon solar cells. Passivated contact cells have a higher efficiency limit, which is closest to the theoretical limit efficiency of 28.7% for crystalline silicon solar cells. Tunnel oxide passivated contact (TOPCon) cells are passively contact by using a tunnel oxide layer and n+-poly-Si on the backside, which can greatly reduce the recombination rate.

The backside passivation of TOPCon solar cell has been well developed, and there is little space for efficiency improvement, while the front side passivation is passivated only by using aluminum oxide, and there is space for further improvement of the passivation performance. Meanwhile, a P-type doped layer on the front side is still formed by conventional high-temperature boron diffusion process at 1050°C, where defects are introduced by high temperature, resulting in a relatively high proportion of concentric circle defects.

### SUMMARY

According to various embodiments of the present application, a solar cell and a preparation method thereof are provided.

In a first aspect, a preparation method of a solar cell is provided according to embodiments of the present application, which includes: providing a silicon wafer, firstly forming a P-type doped layer and an N-type doped layer on a front side and a backside of the silicon wafer, respectively, then forming a first aluminum oxide passivation layer and a second aluminum oxide passivation layer on surfaces of the P-type doped layer and the N-type doped layer, respectively, then forming a first silicon nitride anti-reflection layer and a second silicon nitride anti-reflection layer on surfaces of the first aluminum oxide passivation layer and the second aluminum oxide passivation layer, respectively, and lastly forming an electrode by a screen printing. The P-type doped layer is obtained by vapor deposition, and a deposition temperature is 400°C to 600°C.

In one embodiment, the P-type doped layer is a boron-doped amorphous silicon layer, and a gas atmosphere in which the boron-doped amorphous silicon layer is deposited includes SiH₄, BH₃, and a carrier gas.

In one embodiment, a volume ratio of SiH₄, BH₃, and the carrier gas is 1:4:4 to 1:6:6.

In one embodiment, a thickness of the P-type doped layer is 400 nm to 600 nm.

In one embodiment, prior to forming the P-type doped layer, a first tunneling oxide layer is firstly formed on the front side of the silicon wafer, and the P-type doped layer is then formed on a surface of the first tunneling oxide layer.

In one embodiment, the first tunneling oxide layer is formed on the front side of the silicon wafer by vapor deposition.

In one embodiment, a deposition temperature is 300°C to 500°C.

In one embodiment, the first tunneling oxide layer is a SiOz layer, and a gas atmosphere in which the first tunneling oxide layer is formed includes NzO.

In one embodiment, a thickness of the first tunneling oxide layer is 2 nm to 4 nm.

In one embodiment, after forming the P-type doped layer, a first mask layer is formed on a surface of the P-type doped layer.

In one embodiment, the first mask layer is formed on the surface of the P-type doped layer by vapor deposition.

In one embodiment, a deposition temperature is 400°C to 600°C.

In one embodiment, the first mask layer is a SiOz layer, a gas atmosphere in which the first mask layer is formed includes SiH₄ and NzO, and a volume ratio of SiH₄ and N₂O is 1:6 to 1:10.

In one embodiment, a thickness of the first mask layer is 10 nm to 40 nm.

In one embodiment, the N-type doped layer is obtained by vapor deposition, and a deposition temperature is 350°C to 450°C.

In one embodiment, the N-type doped layer is a phosphorus-doped amorphous silicon layer, and a gas atmosphere in which the phosphorus-doped amorphous silicon layer is deposited includes SiH₄, PH₃, and a carrier gas.

In one embodiment, a volume ratio of SiH₄, BH₃, and the carrier gas is 1:2:4 to 1:3:6.

In one embodiment, a thickness of the N-type doped layer is 80 nm to 150 nm.

In one embodiment, prior to forming the N-type doped layer, a second tunneling oxide layer is firstly formed on the backside of the silicon wafer, and the N-type doped layer is then formed on a surface of the second tunneling oxide layer.

In one embodiment, the second tunneling oxide layer is formed on the backside of the silicon wafer by vapor deposition.

In one embodiment, a deposition temperature is 300°C to 400°C.

In one embodiment, the second tunneling oxide layer is a SiOz layer, and a gas atmosphere in which the second tunneling oxide layer is formed includes NzO.

In one embodiment, a thickness of the second tunneling oxide layer is 1 nm to 2 nm.

In one embodiment, after forming the N-type doped layer, a second mask layer is formed on a surface of the N-type doped layer.

In one embodiment, the second mask layer is formed on the surface of the N-type doped layer by vapor deposition.

In one embodiment, a deposition temperature is 350°C to 450°C.

In one embodiment, the second mask layer is a SiOz layer, a gas atmosphere in which the second mask layer is formed includes SiH₄ and N₂O, and a volume ratio of SiH₄ and N₂O is 1:6 to 1:10.

In one embodiment, a thickness of the second mask layer is 10 nm to 40 nm.

In one embodiment, after forming the P-type doped layer and the N-type doped layer on the front side and the backside of the silicon wafer by vapor deposition, respectively, an annealing treatment is performed, and a temperature of the annealing treatment is 900°C to 1000°C.

In one embodiment, a time of the annealing treatment is 40 min to 60 min.

In one embodiment, a gas atmosphere of the annealing treatment is nitrogen or oxygen.

In a second aspect, a solar cell is provided according to embodiments of the present application, which is prepared by the aforementioned preparation method of the solar cell.

### BRIEF DESCRIPTION OF THE DRAWINGS

To illustrate the technical solutions according to the embodiments of the present application or in the conventional art more clearly, the accompanying drawings for describing the embodiments or the conventional art are introduced briefly in the following. Apparently, the accompanying drawings in the following description are only some embodiments of the present application, and persons of ordinary skill in the art can derive other drawings from the accompanying drawings without creative efforts.
FIG. 1 is a schematic view of a conventional solar cell according to the present application.
FIG. 2 is a schematic view of a solar cell according to an embodiment of the present application.
FIG. 3 is an EL image of a first typical concentric circle defect.
FIG. 4 is an EL image of a second typical concentric circle defect.

Reference numerals: 10, solar cell; 111, front side textured structure; 112, first silicon nitride anti-reflection layer; 113, first aluminum oxide passivation layer; 114, P-type doped layer; 115, first tunneling oxide layer; 116, silicon layer; 117, second tunneling oxide layer; 118, N-type doped layer; 119, second aluminum oxide passivation layer; 120, second silicon nitride anti-reflection layer; 121, front side electrode; 122, backside electrode.

### DETAILED DESCRIPTION OF THE EMBODIMENTS

The technical solutions in the embodiments of the present application will be clearly and completely described hereinafter in combination with the accompanying drawings in the embodiments of the present application. Obviously, the described embodiments are only a part of the embodiments of the present application, but not all of the embodiments. All other embodiments obtained by a person of ordinary skill in the art based on the embodiments in the present application without creative efforts are within the scope of the present application.

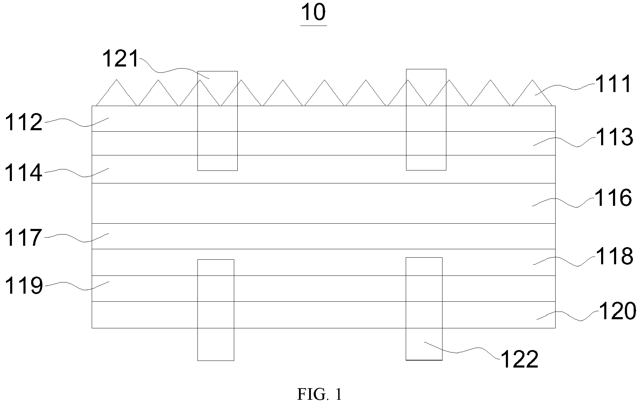

Referring to FIG. 1, a solar cell 10 includes, successively from a front side to a backside, a front side textured structure 111, a first silicon nitride anti-reflection layer 112, a first aluminum oxide passivation layer 113, a P-type doped layer 114, a silicon layer 116, a second tunneling oxide layer 117, an N-type doped layer 118, a second aluminum oxide passivation layer 119, and a second silicon nitride anti-reflection layer 120. A front side electrode 121 and a backside electrode 122 are provided on the front side and the backside of the solar cell, respectively.

The inventors have noticed that the backside passivation of TOPCon solar cell has been well developed, and there is little space for efficiency improvement, while the front side passivation is passivated only by using aluminum oxide, and there is space for further improvement of the passivation performance. Meanwhile, a P-type doped layer on the front side is still formed by conventional high-temperature boron diffusion process at 1050°C, where defects are introduced by high temperature, resulting in a relatively high proportion of concentric circle defects.

Based on the aforementioned considerations, in order to reduce the carrier recombination rate and reduce the proportion of concentric circle defects, after in-depth research, the applicants designed a preparation method of a solar cell, in which the P-type doped layer is formed on the front side of the silicon wafer by *in-situ* doping by vapor deposition. In addition, since a deposition temperature is only 400°C to 600°C, the high-temperature doping process is omitted, which on the one hand can reduce the carrier recombination rate, and the saturation current density (10) can decrease to 13 fA/cm² to 15 fA/cm², on the other hand, can reduce thermal defects formed by high temperature, and the proportion of concentric circle defects can decrease to within 0.5%, thereby improving the yield level of industrial production.

The solar cell and the preparation method thereof according to embodiments of the present application are described in detail as follows:

A preparation method of a solar cell provided in the present application includes the following steps:
S1, texturing.

An N-type silicon wafer is provided. Firstly, a mixed solution including 2wt% hydrogen peroxide and 0.3wt% alkali is used to clean oil stains on a surface of the silicon wafer. Then, texturing is performed using a 1wt% alkaline solution, equipped with an auxiliary texturing additive to slow down a reaction rate. A front side textured structure shaped as a pyramid is formed on the surface of the silicon wafer, which serves to anti reflection and limiting light.

S2, a first tunneling oxide layer, a P-type doped layer, and a first mask layer are formed on a front side.

The first tunneling oxide layer, the P-type doped layer, and the first mask layer are successively formed on the front side of the silicon wafer by plasma enhanced chemical vapor deposition (PECVD).

The first tunneling oxide layer is firstly formed on the front side of the silicon wafer, and the P-type doped layer is then formed on a surface of the first tunneling oxide layer, which facilitates a uniform distribution of the P-type doped layer during deposition. The first mask layer is configured to protect the P-type doped layer from being destroyed during wraparound removing and cleaning processes.

The three layers are deposited in one furnace tube without breaking vacuum.

The first tunneling oxide layer is formed by the following method:
Plasma enhanced chemical vapor deposition is used, and N₂O is introduced. N₂O is ionized into oxygen atoms under radio frequency electric field, and oxygen atoms oxidize a surface of the silicon wafer, forming a SiOz layer, thus the first tunneling oxide layer is obtained.

A thickness of the first tunneling oxide layer is 2 nm to 4 nm.

An introducing flow rate of N₂O is 8,000 sccm to 14,000 sccm.

A deposition temperature is 300°C to 500°C.

A deposition pressure is 100 Pa to 150 Pa.

The P-type doped layer is formed by the following method:
SiH₄, BH₃, and a carrier gas are simultaneously introduced, a boron-doped amorphous silicon layer is deposited on a surface of the first tunneling oxide layer by plasma enhanced chemical vapor deposition, thus the P-type doped layer is obtained.

Using SiH₄ and BH₃ as a deposition gas, and the carrier gas as a carrier gas, the deposition gas is ionized to form a plasma under square wave or sine-cosine wave power supply of 200 kHz to 400 kHz, thereby preparing the boron-doped amorphous silicon layer.

A thickness of the P-type doped layer is 400 nm to 600 nm.

As an example, the thickness of the P-type doped layer can be 400 nm, 410 nm, 420 nm, 430 nm, 440 nm, 450 nm, 460 nm, 470 nm, 480 nm, 490 nm, 500 nm, 510 nm, 520 nm, 530 nm, 540 nm, 550 nm, 560 nm, 570 nm, 580 nm, 590 nm, or 600 nm.

A volume ratio of SiH₄, BH₃, and the carrier gas is 1:4:4 to 1:6:6.

As an example, the volume ratio of SiH₄, BH₃, and the carrier gas can be 1:4:4, 1:5:5, 1:4:5, 1:5:4, 1:4:6, 1:6:4, 1:5:6, 1:6:5, or 1:6:6.

An introducing flow rate of SiH₄ is 2,000 sccm to 5,000 sccm.

The carrier gas is Ar or H₂.

The ionization energies of argon and hydrogen are small, which is easy to glow discharge, such that the introduced reaction gases of SiH₄ and BH₃ are more easily ionized.

The carrier gas is Ar.

A deposition temperature is 400°C to 600°C.

As an example, the deposition temperature can be 400°C, 410°C, 420°C, 430°C, 440°C, 450°C, 460°C, 470°C, 480°C, 490°C, 500°C, 510°C, 520°C, 530°C, 540°C, 550°C, 560°C, 570°C, 580°C, 590°C, or 600°C.

The first mask layer is formed by the following method:
SiH₄ and N₂O are simultaneously introduced, a SiOz layer is deposited on a surface of the P-type doped layer by plasma enhanced chemical vapor deposition, thus the first mask layer is obtained.

A thickness of the first mask layer is 10 nm to 40 nm.

A volume ratio of SiH₄ and N₂O is 1:6 to 1:10.

An introducing flow rate of SiH₄ is 1,000 sccm to 4,000 sccm.

A deposition temperature is 400°C to 600°C.

It should be noted that the first tunneling oxide layer and the first mask layer can also be formed by methods other than PECVD, which is not limited in the present application.

S3, alkaline polishing.

Firstly, the first mask layer wraparound the backside of the silicon wafer is removed using a chain HF machine, with a volume percentage of HF of 40% to 80%. The silicon wafer is then transferred by manipulator to a trough type alkaline polishing machine to remove textured structures and edge p-n junctions on the backside of the silicon wafer using 2wt% alkaline solution and an alkaline polishing additive. Meanwhile, a small textured structure of 0.3 µm to 1 µm is formed on the backside of the silicon wafer.

S4, a second tunneling oxide layer, an N-type doped layer, and a second mask layer are formed on the backside.

The second tunneling oxide layer, the N-type doped layer, and the second mask layer are successively formed on the backside of the silicon wafer by plasma enhanced chemical vapor deposition (PECVD).

The second tunneling oxide layer is firstly formed on the backside of the silicon wafer, and the N-type doped layer is then formed on a surface of the second tunneling oxide layer, which facilitates a uniform distribution of the N-type doped layer during deposition. The second mask layer is configured to protect the N-type doped layer from being destroyed during wraparound removing and cleaning processes.

The three layers are deposited in one furnace tube without breaking vacuum.

The second tunneling oxide layer is formed by the following method:
Plasma enhanced chemical vapor deposition is used, and N₂O is introduced. N₂O is ionized into oxygen atoms under radio frequency electric field, and oxygen atoms oxidize a surface of the silicon wafer, forming a SiOz layer, thus the second tunneling oxide layer is obtained.

A thickness of the second tunneling oxide layer is 1 nm to 2 nm.

An introducing flow rate of N₂O is 6,000 sccm to 12,000 sccm.

A deposition temperature is 300°C to 400°C.

A deposition pressure is 100 Pa to 150 Pa.

The N-type doped layer is formed by the following method:
SiH₄, PH₃, and a carrier gas are simultaneously introduced, a phosphorus-doped amorphous silicon layer is deposited on a surface of the second tunneling oxide layer by plasma enhanced chemical vapor deposition, thus the N-type doped layer is obtained.

A thickness of the N-type doped layer is 80 nm to 150 nm.

A volume ratio of SiH₄, PH₃, and the carrier gas is 1:2:4 to 1:3:6.

An introducing flow rate of SiH₄ is 1,500 sccm to 4,500 sccm.

The carrier gas is Ar or H₂.

The ionization energies of argon and hydrogen are small, which is easy to glow discharge, such that the introduced reaction gases of SiH₄ and PH₃ are more easily ionized.

The carrier gas is H₂.

A deposition temperature is 350°C to 450°C.

The second mask layer is formed by the following method:
SiH₄ and N₂O are simultaneously introduced, a SiOz layer is deposited on a surface of the N-type doped layer by plasma enhanced chemical vapor deposition, thus the second mask layer is obtained.

A thickness of the second mask layer is 10 nm to 40 nm.

A volume ratio of SiH₄ and N₂O is 1:6 to 1:10.

An introducing flow rate of SiH₄ is 1,000 sccm to 4,000 sccm.

A deposition temperature is 350°C to 450°C.

S5, annealing.

An annealing treatment is performed on the silicon wafer separately forming the P-type doped layer and the N-type doped layer.

A temperature of the annealing treatment is 900°C to 1000°C.

As an example, the temperature of the annealing treatment can be 900°C, 910°C, 920°C, 930°C, 940°C, 950°C, 960°C, 970°C, 980°C, 990°C, or 1000°C.

A time of the annealing treatment is 40 min to 60 min.

As an example, the time of the annealing treatment can be 40 min, 45 min, 50 min, 55min, or 60 min.

A gas atmosphere of the annealing treatment is nitrogen or oxygen.

The annealing treatment is performed in a tubular annealing furnace.

In the preparation method of the solar cell in the present application, the annealing treatment is performed after the P-type doped layer and the N-type doped layer are separately formed, such that the P-type doped layer and the N-type doped layer can complete the crystal structure transformation simultaneously. The P-type doped layer and the N-type doped layer are transformed into p+-poly-Si and n+-poly-Si, respectively, which not only can save the energy consumption, and substantially will not increase thermal defects formed by high temperature, since the cell is annealed only once.

S6, RCA cleaning.

Firstly, the second mask layer wraparound the front side of the silicon wafer is removed using a chain HF machine, with a volume percentage of HF of 10% to 40%. The SiO₂ layer wraparound the front side generated during deposition of a third mask layer in step S4 and a phosphorsilicate glass generated during annealing are then removed. The silicon wafer is subsequently transferred to an alkaline bath to remove a front side poly wraparound layer, with a concentration of alkaline solution in the alkaline bath of 3wt% to 6wt%. At this time the N-type doped layer is protected by the third mask layer from being destroyed. After the poly wraparound the front side is removed, the silicon wafer enters into a trough type HF machine to remove the first mask layer formed in step S2 and the second mask layer formed in step S4, with a volume percentage of HF of 10%.

S7, aluminum oxide films are deposited on the front side and the backside.

A first aluminum oxide passivation layer and a second aluminum oxide passivation layer are deposited on surfaces of the P-type doped layer and the N-type doped layer by thermal ALD, respectively.

S8, silicon nitride films are deposited on the front side and the backside.

A first silicon nitride anti-reflection layer and a second silicon nitride anti-reflection layer are deposited on surfaces of the first aluminum oxide passivation layer and the second aluminum oxide passivation layer by plasma enhanced chemical vapor deposition, respectively. The first silicon nitride anti-reflection layer is configured for anti-reflection and hydrogen passivation, and the second silicon nitride anti-reflection layer is configured for hydrogen passivation of a backside film.

S9, front side and backside pastes are screen printed.

Front side and backside pastes are screen printed to manufacture electrodes.

S10, light is injected, efficiency is test and sorted.

In the preparation method of the solar cell according to the present application, the P-type doped layer is formed on the front side of the silicon wafer by *in-situ* doping by vapor deposition, and since the deposition temperature is only 400°C to 600°C, the high-temperature doping process is omitted, which on the one hand can reduce the saturation current density (10) to 13 fA/cm² to 15 fA/cm², on the other hand, enables the proportion of concentric circle defects to decrease to within 0.5%, thereby improving the yield level of industrial production.

The present application also provides a solar cell, which is prepared by the aforementioned preparation method of the solar cell.

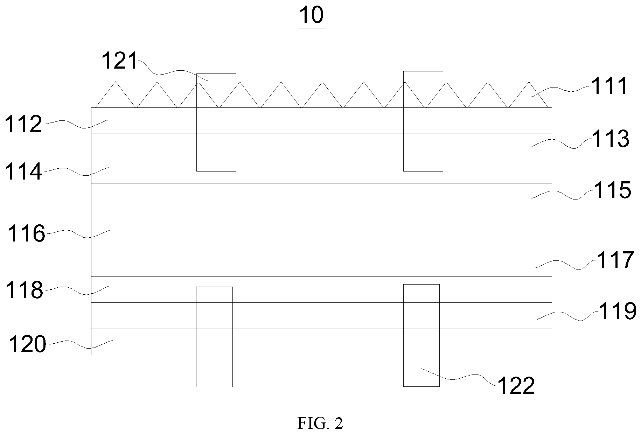

Referring to FIG. 2, a solar cell 10 according to the present application includes, successively from a front side to a backside, a front side textured structure 111, a first silicon nitride anti-reflection layer 112, a first aluminum oxide passivation layer 113, a P-type doped layer 114, a first tunneling oxide layer 115, a silicon layer 116, a second tunneling oxide layer 117, an N-type doped layer 118, a second aluminum oxide passivation layer 119, and a second silicon nitride anti-reflection layer 120. A front side electrode 121 and a backside electrode 122 are provided on the front side and the backside of the solar cell, respectively.

The solar cell according to the present application has a lower saturation current density (10) of 13 fA/cm² to 15 fA/cm², and a lower proportion of concentric circle defects within 0.5%.

In order to make the purposes, technical solutions and advantages of the present application clearer, the technical solutions in embodiments of the present application will be clearly and completely described hereinafter. Embodiments with specific conditions not indicated are carried out under conventional conditions or conditions recommended by the manufacturer. The reagents or instruments used without indication of manufacturer are all conventional products that are commercially available.

### Example 1

A solar cell and a preparation method thereof were provided in the present example, including the following steps:
S 1, texturing.

An N-type silicon wafer was provided. Firstly, a mixed solution including 2wt% hydrogen peroxide and 0.3wt% alkali was used to clean oil stains on a surface of the silicon wafer. Then, texturing was performed using a 1wt% alkaline solution, equipped with an auxiliary texturing additive to slow down a reaction rate. A front side textured structure shaped as a pyramid was formed on the surface of the silicon wafer.

S2, a first tunneling oxide layer, a P-type doped layer, and a first mask layer were formed on a front side.

Plasma enhanced chemical vapor deposition was used, and 12,000 sccm N₂O was introduced. N₂O was ionized into oxygen atoms under radio frequency electric field, and oxygen atoms oxidized a surface of the silicon wafer, forming a SiOz layer, thus the first tunneling oxide layer with a thickness of 2.2 nm was obtained. A deposition temperature was 450°C, and a deposition pressure was 120 Pa.

2,000 sccm SiH₄, 8,000 sccm BH₃, and 8,000 sccm Ar were simultaneously introduced, a boron-doped amorphous silicon layer was deposited on a surface of the first tunneling oxide layer by plasma enhanced chemical vapor deposition, thus the P-type doped layer with a thickness of 500 nm was obtained. A deposition temperature was 550°C.

1,500 sccm SiH₄ and 12,000 sccm N₂O were simultaneously introduced, a SiOz layer was deposited on a surface of the P-type doped layer by plasma enhanced chemical vapor deposition, thus the first mask layer with a thickness of 30 nm was obtained. A deposition temperature was 450°C.

The three layers were deposited in one furnace tube without breaking vacuum.

S3, alkaline polishing.

Firstly, the first mask layer wraparound the backside of the silicon wafer was removed using a chain HF machine, with a volume percentage of HF of 60%. The silicon wafer was then transferred by manipulator to a trough type alkaline polishing machine to remove textured structures and edge p-n junctions on the backside of the silicon wafer using 2wt% alkaline solution and an alkaline polishing additive. Meanwhile, a small textured structure of 0.8 µm was formed on the backside of the silicon wafer.

S4, a second tunneling oxide layer, an N-type doped layer, and a second mask layer were formed on the backside.

Plasma enhanced chemical vapor deposition was used, and 10,000 sccm N₂O was introduced. N₂O was ionized into oxygen atoms under radio frequency electric field, and oxygen atoms oxidized a surface of the silicon wafer, forming a SiOz layer, thus the second tunneling oxide layer with a thickness of 1.5 nm was obtained. A deposition temperature was 350°C, and a deposition pressure was 120 Pa.

2,500 sccm SiH₄, 5,000 sccm PH₃, and 10,000 sccm Ar were simultaneously introduced, a phosphorus-doped amorphous silicon layer was deposited on a surface of the second tunneling oxide layer by plasma enhanced chemical vapor deposition, thus the N-type doped layer with a thickness of 110 nm was obtained. A deposition temperature was 400°C.

1,500 sccm SiH₄ and 12,000 sccm N₂O were simultaneously introduced, a SiOz layer was deposited on a surface of the N-type doped layer by plasma enhanced chemical vapor deposition, thus the second mask layer with a thickness of 30 nm was obtained. A deposition temperature was 400°C.

The three layers were deposited in one furnace tube without breaking vacuum.

S5, annealing.

An annealing treatment was performed on the silicon wafer forming the P-type doped layer and the N-type doped layer. A temperature of the annealing treatment was 920°C, a time of the annealing treatment was 60 min, and a gas atmosphere of the annealing treatment was nitrogen.

S6, RCA cleaning.

Firstly, the second mask layer wraparound the front side of the silicon wafer was removed using a chain HF machine, with a volume percentage of HF of 30%. The SiO₂ layer wraparound the front side generated during deposition of a third mask layer in step S4 and a phosphorosilicate glass generated during annealing were then removed. The silicon wafer was subsequently transferred to an alkaline bath to remove a front side poly wraparound layer, with a concentration of alkaline solution in the alkaline bath of 4wt%. At this time the N-type doped layer was protected by the third mask layer from being destroyed. After the poly wraparound the front side was removed, the silicon wafer entered into a trough type HF machine to remove the first mask layer formed in step S2 and the second mask layer formed in step S4, with a volume percentage of HF of 10%.

S7, aluminum oxide films were deposited on the front side and the backside.

A first aluminum oxide passivation layer and a second aluminum oxide passivation layer were deposited on surfaces of the P-type doped layer and the N-type doped layer by thermal ALD, respectively.

S8, silicon nitride films were deposited on the front side and the backside.

A first silicon nitride anti-reflection layer and a second silicon nitride anti-reflection layer were deposited on surfaces of the first aluminum oxide passivation layer and the second aluminum oxide passivation layer by plasma enhanced chemical vapor deposition, respectively.

S9, front side and backside pastes were screen printed.

Front side and backside pastes were screen printed to manufacture electrodes.

S10, light was injected, efficiency was test and sorted.

### Example 2

A solar cell and a preparation method thereof were provided in the present example. On the basis of Example 1, a part of step S2 that a first tunneling oxide layer, a P-type doped layer, and a first mask layer were formed on a front side, was changed in Example 2. 2,000 sccm SiH₄, 10,000 sccm BH₃, and 10,000 sccm Ar were simultaneously introduced, a boron-doped amorphous silicon layer was deposited on a surface of the first tunneling oxide layer by plasma enhanced chemical vapor deposition, thus the P-type doped layer with a thickness of 500 nm was obtained. A deposition temperature was 550°C. Other conditions remained unchanged.

### Example 3

A solar cell and a preparation method thereof were provided in the present example. On the basis of Example 1, a part of step S2 that a first tunneling oxide layer, a P-type doped layer, and a first mask layer were formed on a front side, was changed in Example 3. 2,000 sccm SiH₄, 12,000 sccm BH₃, and 12,000 sccm Ar were simultaneously introduced, a boron-doped amorphous silicon layer was deposited on a surface of the first tunneling oxide layer by plasma enhanced chemical vapor deposition, thus the P-type doped layer with a thickness of 500 nm was obtained. A deposition temperature was 550°C. Other conditions remained unchanged.

### Example 4

A solar cell and a preparation method thereof were provided in the present example. On the basis of Example 1, a part of step S2 that a first tunneling oxide layer, a P-type doped layer, and a first mask layer were formed on a front side, was changed in Example 4. 2,000 sccm SiH₄, 8,000 sccm BH₃, and 8,000 sccm Ar were simultaneously introduced, a boron-doped amorphous silicon layer was deposited on a surface of the first tunneling oxide layer by plasma enhanced chemical vapor deposition, thus the P-type doped layer with a thickness of 500 nm was obtained. A deposition temperature was 400°C. Other conditions remained unchanged.

### Example 5

A solar cell and a preparation method thereof were provided in the present example. On the basis of Example 1, a part of step S2 that a first tunneling oxide layer, a P-type doped layer, and a first mask layer were formed on a front side, was changed in Example 5. 2,000 sccm SiH₄, 8,000 sccm BH₃, and 8,000 sccm Ar were simultaneously introduced, a boron-doped amorphous silicon layer was deposited on a surface of the first tunneling oxide layer by plasma enhanced chemical vapor deposition, thus the P-type doped layer with a thickness of 500 nm was obtained. A deposition temperature was 600°C. Other conditions remained unchanged.

### Example 6

A solar cell and a preparation method thereof were provided in the present example. On the basis of Example 1, a part of step S2 that a first tunneling oxide layer, a P-type doped layer, and a first mask layer were formed on a front side, was changed in Example 6. 2,000 sccm SiH₄, 8,000 sccm BH₃, and 8,000 sccm Ar were simultaneously introduced, a boron-doped amorphous silicon layer was deposited on a surface of the first tunneling oxide layer by plasma enhanced chemical vapor deposition, thus the P-type doped layer with a thickness of 400 nm was obtained. A deposition temperature was 550°C. Other conditions remained unchanged.

### Example 7

A solar cell and a preparation method thereof were provided in the present example. On the basis of Example 1, a part of step S2 that a first tunneling oxide layer, a P-type doped layer, and a first mask layer were formed on a front side, was changed in Example 7. 2,000 sccm SiH₄, 8,000 sccm BH₃, and 8,000 sccm Ar were simultaneously introduced, a boron-doped amorphous silicon layer was deposited on a surface of the first tunneling oxide layer by plasma enhanced chemical vapor deposition, thus the P-type doped layer with a thickness of 600 nm was obtained. A deposition temperature was 550°C. Other conditions remained unchanged.

### Comparative Example 1

A solar cell and a preparation method thereof were provided in the present comparative example, including the following steps:
S1, texturing.

An N-type silicon wafer was provided. Firstly, a mixed solution including 2wt% hydrogen peroxide and 0.3wt% alkali was used to clean oil stains on a surface of the silicon wafer. Then, texturing was performed using a 1wt% alkaline solution, equipped with an auxiliary texturing additive to slow down a reaction rate. A front side textured structure shaped as a pyramid was formed on the surface of the silicon wafer.

S2, a P-type doped layer was formed.

After cleaning and drying, the silicon wafer entered into a boron diffusion furnace, the P-type doped layer was formed using diffusion of BCl₃ and oxygen at 1040°C. A ratio of BCl₃ and oxygen was 1: 15, and a volume proportion of BCl₃ in a gas atmosphere of the furnace tube was 1.4%. Through the high-temperature diffusion, a borosilicate glass layer (BSG) of 120 nm was formed on the surface of the N-type silicon wafer, with a square resistance of 120 Ω/sq.

S3, alkaline polishing.

Firstly, BSG wraparound the backside of the silicon wafer after boron diffusion was removed using a chain HF machine, with a volume percentage of HF of 60%. The silicon wafer was then transferred by manipulator to a trough type alkaline polishing machine to remove p-n junctions on the backside and the edge of the silicon wafer using 2% alkaline solution and an alkaline polishing additive. Meanwhile, a small textured structure of 0.8 µm was formed on the backside of the silicon wafer.

S4, a second tunneling oxide layer, an N-type doped layer, and a second mask layer were formed on the backside.

Plasma enhanced chemical vapor deposition was used, and 10,000 sccm N₂O was introduced. N₂O was ionized into oxygen atoms under radio frequency electric field, and oxygen atoms oxidized a surface of the silicon wafer, forming a SiOz layer, thus the second tunneling oxide layer with a thickness of 1.5 nm was obtained. A deposition temperature was 350°C, and a deposition pressure was 120 Pa.

2,500 sccm SiH₄, 5,000 sccm PH₃, and 10,000 sccm Ar were simultaneously introduced, a phosphorus-doped amorphous silicon layer was deposited on a surface of the second tunneling oxide layer by plasma enhanced chemical vapor deposition, thus the N-type doped layer with a thickness of 110 nm was obtained. A deposition temperature was 400°C.

1,500 sccm SiH₄ and 12,000 sccm N₂O were simultaneously introduced, a SiOz layer was deposited on a surface of the N-type doped layer by plasma enhanced chemical vapor deposition, thus the second mask layer with a thickness of 30 nm was obtained. A deposition temperature was 400°C.

The three layers were deposited in one furnace tube without breaking vacuum.

S5, annealing.

An annealing treatment was performed on the silicon wafer forming the P-type doped layer and the N-type doped layer. A temperature of the annealing treatment was 900°C, a time of the annealing treatment was 60 min, and a gas atmosphere of the annealing treatment was nitrogen.

S6, RCA cleaning.

Firstly, the second mask layer wraparound the front side of the silicon wafer was removed using a chain HF machine, with a volume percentage of HF of 30%. The SiO₂ layer wraparound the front side generated during deposition of a third mask layer in step S4 and a phosphorosilicate glass generated during annealing were then removed. The silicon wafer was subsequently transferred to an alkaline bath to remove a front side poly wraparound layer, with a concentration of alkaline solution in the alkaline bath of 4wt%. At this time the N-type doped layer was protected by the third mask layer from being destroyed. After the poly wraparound the front side was removed, the silicon wafer entered into a trough type HF machine to remove the first mask layer formed in step S2 and the second mask layer formed in step S4, with a volume percentage of HF of 10%.

S7, aluminum oxide films were deposited on the front side and the backside.

A first aluminum oxide passivation layer and a second aluminum oxide passivation layer were deposited on surfaces of the P-type doped layer and the N-type doped layer by thermal ALD, respectively.

S8, silicon nitride films were deposited on the front side and the backside.

A first silicon nitride anti-reflection layer and a second silicon nitride anti-reflection layer were deposited on surfaces of the first aluminum oxide passivation layer and the second aluminum oxide passivation layer by plasma enhanced chemical vapor deposition, respectively.

S9, front side and backside pastes were screen printed.

Front side and backside pastes were screen printed to manufacture electrodes.

S10, light was injected, efficiency was test and sorted.

The structure of the solar cell prepared was shown in FIG. 1, the solar cell 10 included, successively from the front side to the backside, a front side textured structure 111, the first silicon nitride anti-reflection layer 112, the first aluminum oxide passivation layer 113, the P-type doped layer 114, the silicon layer 116, the second tunneling oxide layer 117, the N-type doped layer 118, the second aluminum oxide passivation layer 119, and the second silicon nitride anti-reflection layer 120. A front side electrode 121 and a backside electrode 122 were provided on the front side and the backside of the solar cell, respectively.

### Experimental Example 1

Sinton test and I-V test were carried out on the solar cells prepared in Examples 1 to 7 and Comparative Example 1, and the proportion of concentric circle defects was detected. The results are shown in Table 1.

The proportion of concentric circle defects was detected by the following method:

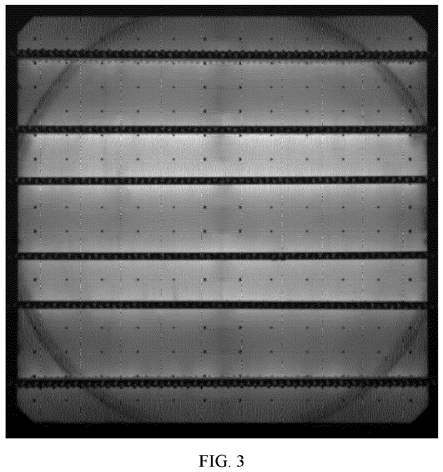

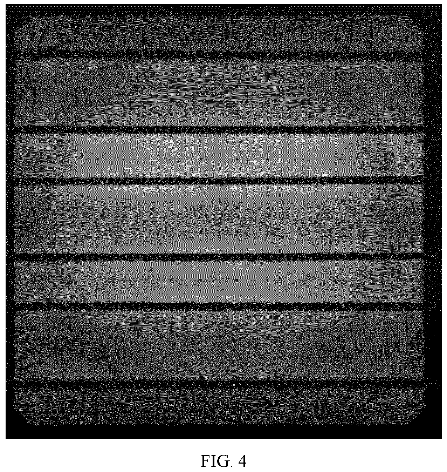

Electroluminescent was used, which also known as electric field luminescence, EL for short, is a physical phenomenon of luminescence caused by the transition, change and recombination of electrons between energy levels leading by electron collisions excited by an electric field, and the electric field is generated by applying a voltage to both electrodes. The test condition was to load a reverse-biased 12V direct-current power (DC-12V) between the electrodes of the cell, and EL images were formed by infrared camera imaging. EL images of typical concentric circle defects are shown in FIGS 3 to 4.

**Table 1 Results of Sinton test, I-V test, and the proportion of concentric circle defects of the solar cells prepared in Examples 1 to 7 and Comparative Example 1.**

| Item | Sinton test | | I-V test | | | proportion of concentric circle defects (%) |
|---|---|---|---|---|---|---|
| | iVoc (mV) | J0 (fA/cm²) | Eta (%) | Voc (%) | Isc (A) | |
| Example 1 | 738.9 | 14.3 | 25.34 | 721.2 | 13.79 | 0.32 |
| Example 2 | 737.7 | 14.8 | 25.35 | 720.2 | 13.82 | 0.42 |
| Example 3 | 736.2 | 15.2 | 25.31 | 719.0 | 13.78 | 0.35 |
| Example 4 | 737.3 | 14.4 | 25.41 | 721.1 | 13.81 | 0.27 |
| Example 5 | 738.1 | 14.7 | 25.31 | 719.2 | 13.81 | 0.31 |
| Example 6 | 738.6 | 14.1 | 25.41 | 721.5 | 13.82 | 0.44 |
| Example 7 | 738.4 | 14.2 | 25.33 | 721.2 | 13.80 | 0.37 |
| Comparative Example 1 | 731.5 | 17.8 | 25.09 | 714.1 | 13.79 | 3.8 |

According to Examples 1 to 7, the solar cells prepared by the preparation method of the solar cell according to examples of the present application, have a saturation current density (10) of 13 fA/cm², and a proportion of concentric circle defects within 0.5%.

According to the comparison of Comparative Example 1 and Examples 1 to 7, the solar cell that the P-type doped layer was formed by a boron diffusion high-temperature process, has a higher saturation current density (J0) of 17.8 fA/cm², and a higher proportion of concentric circle defects of 3.8%. That is to say, in the preparation method of the solar cell according to examples of the present application, the boron diffusion high-temperature process is replaced by plasma enhanced chemical vapor deposition, which reduces the carrier recombination rate and the proportion of concentric circle defects of the prepared solar cell. In addition, the P-type doped layers formed in Examples 1 to 7 and Comparative Example 1 are different, the P-type doped layer formed in Examples 1 to 7 is a layer of polycrystalline silicon containing boron (p+-poly-Si) that is deposited on the silicon wafer, while the P-type doped layer formed in Comparative Example 1 is substantially a monocrystalline silicon layer (p+ layer) that boron atoms are doped in the N-type silicon wafer, and form covalent bonds with silicon atoms in the silicon wafer.

Each of the technical features of the above-mentioned embodiments may be combined arbitrarily. To simplify the description, not all the possible combinations of each of the technical features in the above embodiments are described. However, all of the combinations of these technical features should be considered as within the scope of the present application, as long as such combinations do not contradict with each other.

The above embodiments merely illustrate several embodiments of the present application, and the description thereof is specific and detailed, but it shall not be constructed as limiting the scope of the present application. It should be noted that a plurality of variations and modifications may be made by those skilled in the art without departing from the scope of the present application, which are all within the scope of protection of the present application. Therefore, the protection scope of the present application shall be subject to the appended claims.

## Claims

1. A preparation method of a solar cell, comprising: providing a silicon wafer, firstly forming a P-type doped layer and an N-type doped layer on a front side and a backside of the silicon wafer, respectively, then forming a first aluminum oxide passivation layer and a second aluminum oxide passivation layer on surfaces of the P-type doped layer and the N-type doped layer, respectively, then forming a first silicon nitride anti-reflection layer and a second silicon nitride anti-reflection layer on surfaces of the first aluminum oxide passivation layer and the second aluminum oxide passivation layer, respectively, and lastly forming an electrode by a screen printing;
wherein the P-type doped layer is obtained by vapor deposition, and a deposition temperature is 400°C to 600°C.

2. The preparation method of the solar cell according to claim 1, wherein the P-type doped layer is a boron-doped amorphous silicon layer, and a gas atmosphere in which the boron-doped amorphous silicon layer is deposited comprises SiH₄, BH₃, and a carrier gas.

3. The preparation method of the solar cell according to claim 1, wherein a volume ratio of SiH₄, BH₃, and the carrier gas is 1:4:4 to 1:6:6.

4. The preparation method of the solar cell according to claim 1, wherein a thickness of the P-type doped layer is 400 nm to 600 nm.

5. The preparation method of the solar cell according to claim 1, wherein prior to forming the P-type doped layer, a first tunneling oxide layer is firstly formed on the front side of the silicon wafer, and the P-type doped layer is then formed on a surface of the first tunneling oxide layer.

6. The preparation method of the solar cell according to claim 1, wherein the first tunneling oxide layer is formed on the front side of the silicon wafer by vapor deposition.

7. The preparation method of the solar cell according to claim 1, wherein a deposition temperature is 300°C to 500°C.

8. The preparation method of the solar cell according to claim 1, wherein the first tunneling oxide layer is a SiOz layer, and a gas atmosphere in which the first tunneling oxide layer is formed comprises N₂O.

9. The preparation method of the solar cell according to claim 1, wherein a thickness of the first tunneling oxide layer is 2 nm to 4 nm.

10. The preparation method of the solar cell according to claim 1, wherein after forming the P-type doped layer, a first mask layer is formed on a surface of the P-type doped layer.

11. The preparation method of the solar cell according to claim 1, wherein the first mask layer is formed on the surface of the P-type doped layer by vapor deposition.

12. The preparation method of the solar cell according to claim 1, wherein a deposition temperature is 400°C to 600°C.

13. The preparation method of the solar cell according to claim 1, wherein the first mask layer is a SiOz layer, a gas atmosphere in which the first mask layer is formed comprises SiH₄ and NzO, and a volume ratio of SiH₄ and N₂O is 1:6 to 1:10.

14. The preparation method of the solar cell according to claim 1, wherein a thickness of the first mask layer is 10 nm to 40 nm.

15. The preparation method of the solar cell according to claim 1, wherein the N-type doped layer is obtained by vapor deposition, and a deposition temperature is 350°C to 450°C.

16. The preparation method of the solar cell according to claim 1, wherein the N-type doped layer is a phosphorus-doped amorphous silicon layer, and a gas atmosphere in which the phosphorus-doped amorphous silicon layer is deposited comprises SiH₄, PH₃, and a carrier gas.

17. The preparation method of the solar cell according to claim 1, wherein a volume ratio of SiH₄, PH₃, and the carrier gas is 1:2:4 to 1:3:6.

18. The preparation method of the solar cell according to claim 1, wherein a thickness of the N-type doped layer is 80 nm to 150 nm.

19. The preparation method of the solar cell according to claim 15, wherein prior to forming the N-type doped layer, a second tunneling oxide layer is firstly formed on the backside of the silicon wafer, and the N-type doped layer is then formed on a surface of the second tunneling oxide layer.

20. The preparation method of the solar cell according to any one of claims 15 to 18, wherein the second tunneling oxide layer is formed on the backside of the silicon wafer by vapor deposition.

21. The preparation method of the solar cell according to any one of claims 15 to 18, wherein a deposition temperature is 300°C to 400°C.

22. The preparation method of the solar cell according to any one of claims 15 to 18, wherein the second tunneling oxide layer is a SiOz layer, and a gas atmosphere in which the second tunneling oxide layer is formed comprises N₂O.

23. The preparation method of the solar cell according to any one of claims 15 to 18, wherein a thickness of the second tunneling oxide layer is 1 nm to 2 nm.

24. The preparation method of the solar cell according to any one of claims 15 to 18, wherein after forming the N-type doped layer, a second mask layer is formed on a surface of the N-type doped layer.

25. The preparation method of the solar cell according to any one of claims 15 to 18, wherein the second mask layer is formed on the surface of the N-type doped layer by vapor deposition.

26. The preparation method of the solar cell according to any one of claims 15 to 18, wherein a deposition temperature is 350°C to 450°C.

27. The preparation method of the solar cell according to any one of claims 15 to 18, wherein the second mask layer is a SiOz layer, a gas atmosphere in which the second mask layer is formed comprises SiH₄ and NzO, and a volume ratio of SiH₄ and N₂O is 1:6 to 1:10.

28. The preparation method of the solar cell according to any one of claims 15 to 18, wherein a thickness of the second mask layer is 10 nm to 40 nm.

29. The preparation method of the solar cell according to any one of claims 15 to 18, wherein after forming the P-type doped layer and the N-type doped layer on the front side and the backside of the silicon wafer by vapor deposition, respectively, an annealing treatment is performed, and a temperature of the annealing treatment is 900°C to 1000°C.

30. The preparation method of the solar cell according to any one of claims 15 to 18, wherein a time of the annealing treatment is 40 min to 60 min.

31. The preparation method of the solar cell according to any one of claims 15 to 18, wherein a gas atmosphere of the annealing treatment is nitrogen or oxygen.

32. A solar cell prepared by the preparation method of the solar cell according to any one of claims 1 to 31.
